# EUROPEAN PATENT APPLICATION

(11) **EP 4 704 345 A1**
(43) Date of publication of application: **04.03.2026**
(21) Application number: 25178733.9
(22) Date of filing: 26.05.2025
(51) Int. Cl.: H03L 7/093, H03L 7/099

(54) **DIGITAL PHASE-LOCKED LOOP, ELECTRONIC DEVICE, AND METHOD OF OPERATING DIGITAL PHASE-LOCKED LOOP FOR TUNING FREQUENCY AND CORRECTING PHASE ERROR BY USING PULSE SIGNAL-BASED VARIABLE CAPACITANCE**

(30) Priority: 26.08.2024 KR 20240114488; 21.10.2024 KR 20240144351
(71) Applicant: Samsung Electronics Co., Ltd., Suwon-si, Gyeonggi-do 16677 (KR)
(72) Inventor: KIM, Insung, 16677 Suwon-si (KR); KIM, Wooseok, 16677 Suwon-si (KR); YU, Wonsik, 16677 Suwon-si (KR)
(74) Representative: Marks & Clerk LLP

(57) **Abstract**

Provided are a digital phase-locked loop for tuning a frequency and correcting a phase error by using pulse signal-based variable capacitance, an electronic device, and a method of operating the digital phase-locked loop. The digital phase-locked loop includes a phase detector for comparing phases between a reference signal and a feedback signal, a digital loop filter for outputting an adjustment signal that regulates a duty ratio for a first period, based on an up-down signal of the phase detector, a variable capacitance controller for outputting a capacitance control signal having the duty ratio, based on the feedback signal, the adjustment signal, and the up-down signal, a digitally controlled oscillator for changing first capacitance of a capacitor bank circuit, based on the capacitance control signal, and adjusting a phase based on an average of the first capacitance during the first period, and a divider for dividing an output signal.

## Description

### BACKGROUND

The disclosure relates to an electronic device, and more particularly, to a digital phase-locked loop for tuning a frequency and correcting a phase error by using pulse signal-based variable capacitance, an electronic device, and a method of operating the digital phase-locked loop.

In electronic systems, such as wireless systems and wired systems, there is a growing demand for phase-locked loops (PLLs) for high-data rate communication, high-speed data signal processing, and high performance jitter specifications.

For charge pump PLLs (CPPLLs), which typically include a charge pump, there are structural difficulties in improving low jitter. In addition, for sampling PLLs (SPLLs) such as sub-sampling PLLs, the lock range (or lock in range) required to achieve phase lock is relatively narrow, and thus, it is difficult to obtain stable phase lock. In order to secure the lock range, a separate loop, such as a frequency locking loop, is added to the sampling PLL, which makes it difficult to reduce manufacturing costs or to promote integration.

For digital PLLs including LC tank oscillators (LCOSC), a target frequency is adjusted by the inductance and total capacitance values of an LC tank. In this case, the frequency variations are adjusted based on tuning the capacitance values of capacitors, and a varactor that receives a DC voltage input and has a corresponding capacitance may be used as a variable capacitor. However, the varactor is susceptible to supply noise and has a large capacitance variation according to a change in temperature, and the low quality factor of the varactor causes a bottleneck in the quality factor of the LC tank. Therefore, it is necessary to find a way to correct the frequency and phase by finely adjusting the capacitance while replacing the varactor.

### SUMMARY

Embodiments provide a digital phase-locked loop for tuning a frequency and correcting a phase by using pulse signal-based variable capacitance rather than a varactor, an electronic device, and a method of operating the digital phase-locked loop.

According to an aspect of the disclosure, a digital phase-locked loop includes: a phase detector configured to compare a phase of a reference signal and a phase of the feedback signal, and output an up-down signal representing a result of the comparison; a digital loop filter configured to output, based on the up-down signal, an adjustment signal including digital code for adjusting a duty ratio for a first period corresponding to a period of the feedback signal; a variable capacitance controller configured to output, based on the feedback signal, the adjustment signal, and the up-down signal, a capacitance control signal having the duty ratio; a digitally controlled oscillator including: an inductor, a capacitor bank circuit configured to change a first capacitance based on the capacitance control signal, and a negative voltage-current converter configured to output an output signal having a phase adjusted based on inductance of the inductor and an average of the first capacitance during the first period; and a divider configured to generate the feedback signal by dividing the output signal.

According to an aspect of the disclosure, a method of operating a digital phase-locked loop, the method includes: generating, based on a reference signal and a feedback signal, an up-down signal representing a result of a comparison of a phase of the reference signal and a phase of the feedback signal; generating, based on the up-down signal, an adjustment signal including digital code for adjusting a duty ratio for a first period corresponding to a period of the feedback signal; generating, based on the feedback signal, the adjustment signal, and the up-down signal, a capacitance control signal having the duty ratio; setting a first capacitance during a second period corresponding to the duty ratio of the capacitance control signal; adjusting a phase, based on inductance and an average of the first capacitance during the first period, to generate an output signal having the phase; and generating the feedback signal by dividing the output signal.

According to an aspect of the disclosure, a an electronic device for generating an output clock signal, based on a reference clock signal, the electronic device including: a phase detector configured to compare a phase of a reference clock signal and a phase of the feedback clock signal, and output an up-down signal representing a result of the comparison; a digital loop filter configured to output, based on the up-down signal, an adjustment signal including digital code for adjusting a duty ratio for a first period corresponding to a period of the feedback clock signal; a variable capacitance controller configured to output, based on the feedback clock signal, the adjustment signal, and the up-down signal, a capacitance control signal having the duty ratio; a digitally controlled oscillator configured to change capacitance of a capacitor bank circuit, based on the capacitance control signal, and adjust a phase of the output clock signal, based on an average of the capacitance during the first period; and a divider configured to generate the feedback clock signal by dividing the output clock signal.

According to one or more embodiments, the capacitor bank replacing the varactor is utilized to tune the frequency and phase. Accordingly, the effect of improving power supply rejection ratio (PSRR) characteristics due to the varactor, the effect of improving the jitter performance of the digitally controlled oscillator, the effect of improving frequency drift due to changes in temperature, and the effect of improving the quality of service (QoS) of the digitally controlled oscillator or the quality factor Q of an LC tank may be achieved.

At least some of the above and other features of the invention are set out in the claims.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 is a block diagram of a digital phase-locked loop according to the one or more embodiments;
FIG. 2 is a block diagram of a digital phase-locked loop according to one or more embodiments;
FIG. 3 is a circuit diagram of a digitally controlled oscillator according to one or more embodiments;
FIG. 4 is a timing chart of signals in the digital phase-locked loop according to one or more embodiments;
FIGS. 5 and 6 are block diagrams of adaptive bandwidth calibration (ABC) according to embodiments;
FIG. 7 is a block diagram of pulse width modulation (PWM) according to one or more embodiments;
FIG. 8 is a circuit diagram of a pulse generator according to one or more embodiments;
FIG. 9 is a circuit diagram of a delay cell according to one or more embodiments;
FIG. 10 is a timing chart of the signals shown in FIGS. 8 and 9;
FIG. 11 is a diagram illustrating variable capacitance;
FIG. 12 is a flowchart illustrating a method of operating a digital phase-locked loop, according to one or more embodiments;
FIG. 13 is a flowchart illustrating one example of operation S200 of FIG. 12;
FIG. 14 is a flowchart illustrating another example of operation S200 of FIG. 12;
FIG. 15 is a flowchart illustrating one example of operation S300 of FIG. 12;
FIG. 16 is a flowchart illustrating one example of operation S320 of FIG. 15; and
FIG. 17 is a block diagram of an electronic device according to one or more embodiments.

### DETAILED DESCRIPTION

Hereinafter, embodiments are described in detail with reference to the accompanying drawings.

As used herein, the expressions "first," "second," and the like may modify various components, regardless of order and/or importance, and are only used to distinguish one component from other components and do not limit the components. For example, a first user device and a second user device may represent different user devices, regardless of order or importance. For example, a first component may be referred to as a second component, and similarly, a second component may be referred to as a first component.

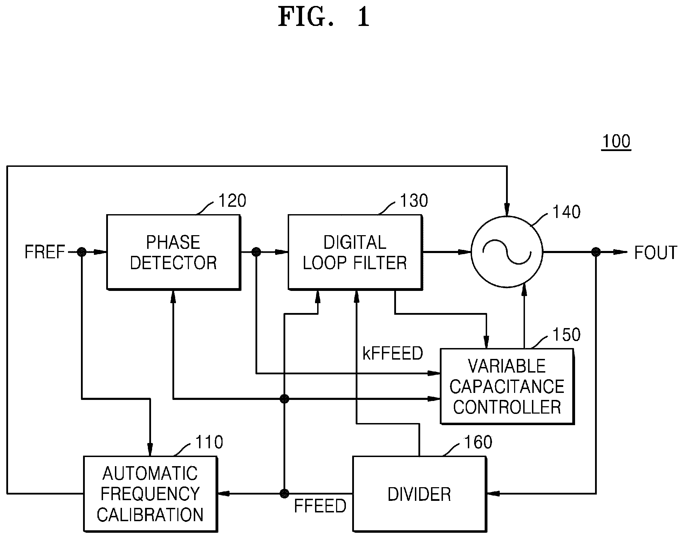

FIG. 1 is a block diagram of a digital phase-locked loop 100 according to an embodiment.

Referring to FIG. 1, the digital phase-locked loop 100 may generate an output signal FOUT based on a reference signal FREF and a feedback signal FFEED. The reference signal FREF may be generated by a crystal oscillator or the like. The reference signal FREF may have a reference frequency. The feedback signal FFEED may include a signal that is divided from the output signal FOUT by a divider 160. The feedback signal FFEED may have a feedback frequency, and the feedback frequency may be less than an output frequency of the output signal FOUT. The output signal FOUT may have an output frequency, and the output frequency of the output signal FOUT, which is ideal or matched to a target signal, may be obtained by the product of a reference frequency and a required multiple. In an embodiment, the reference signal FREF, the feedback signal FFEED, and the output signal FOUT may be used as clock signals for sampling received data or synchronizing the timing of internal operations. The reference signal FREF, the feedback signal FFEED, and the output signal FOUT may be referred to herein as the reference clock signal, the feedback clock signal, and the output clock signal, respectively.

The digital phase-locked loop 100 may include an automatic frequency calibration 110 (e.g. an automatic frequency calibrator), a phase detector 120, a digital loop filter 130, a digitally controlled oscillator 140, a variable capacitance controller 150, and the divider 160.

The automatic frequency calibration 110 may, during a coarse tuning (or rough tuning) operation of the digital phase-locked loop 100, generate digital code for tuning an output frequency of the output signal FOUT such that the output frequency of the output signal FOUT varies within a preset frequency range. Based on the reference signal FREF and the feedback signal FFEED, the automatic frequency calibration 110 may provide the digitally controlled oscillator 140 with digital code for tuning the output frequency of the output signal FOUT.

The phase detector 120 may compare the phase of the reference signal FREF to the phase of the feedback signal FFEED and may output the comparison result. For example, the comparison result may indicate that the phase of the feedback signal FFEED is faster than the phase of the reference signal FREF or may indicate that the phase of the feedback signal FFEED is slower than the phase of the reference signal FREF. The phase detector 120 may determine whether the phase of the reference signal FREF is ahead of or behind the phase of the feedback signal FFEED or whether the phase of the reference signal FREF leads or lags behind the phase of the feedback signal FFEED, and may provide the determination result to the digital loop filter 130.

The digital loop filter 130 may change a loop gain of the digital phase-locked loop 100 during a gear-shifting operation of the digital phase-locked loop 100 and may set, as a target loop gain, the loop gain that is finally changed during the gear-shifting operation. The loop gain may correspond to a compensation amount that compensates for the phase difference between the phase of the reference signal FREF and the phase of the feedback signal FFEED. For example, as the loop gain increases, the compensation amount for phase differences may increase. Also, as the loop gain decreases, the compensation amount for phase differences may decrease.

The digital loop filter 130 may provide the digitally controlled oscillator 140 with pieces of digital code to compensate for a phase difference between the phase of the reference signal FREF and the phase of the feedback signal FFEED based on the set target loop gain. In an embodiment, the digital loop filter 130 may include a proportional path, an integral path, or the like. The proportional path has a value of proportional gain Kp, and the integral path may be implemented as an integral gain Ki and an integrator. The digital loop filter 130 may receive the feedback signal FFEED from the divider 160, and may update the value of the output code for controlling the frequency of the digitally controlled oscillator 140 at each period of the feedback signal FFEED based on the output value of the phase detector 120. In addition, the digital loop filter 130 may receive a k-times feedback signal kFFEED to perform an operation for improving the frequency resolution of the digitally controlled oscillator 140. k may be an integer greater than or equal to 2, and may be set to achieve a relatively small resolution.

The digital loop filter 130 may generate pieces of digital code to adjust a duty ratio (or a duty cycle) of a pulse signal generated by the variable capacitance controller 150.

The digitally controlled oscillator 140 may adjust the output frequency of the output signal FOUT and generate the output signal FOUT based on the received digital code and/or pulse signals. In one or more embodiments, the digitally controlled oscillator 140 may be implemented as an LC oscillator including inductors and capacitors. The output frequency according to the LC oscillator-based digitally controlled oscillator 140 may be set based on the inductance of the inductor and the capacitance of the capacitor. For example, the output frequency may be inversely proportional to the square root of the product of inductance and capacitance. In one or more embodiments, the LC oscillator-based digitally controlled oscillator 140 may include an inductor, a plurality of capacitor banks, and a negative voltage-current converter in a cross-coupled structure for providing negative resistance. The voltage-current converter may be referred to as a transconductance (or gm) cell. The plurality of capacitor banks may provide capacitance based on digital code or pulse signals. The combined capacitance of the digitally controlled oscillator 140 may be varied depending on the capacitance provided by the plurality of capacitor banks, and accordingly, the output frequency may change. In one or more embodiments, the plurality of capacitor banks may include some capacitor banks that replace varactors.

The variable capacitance controller 150 may provide the digitally controlled oscillator 140 with a pulse signal for tuning the output frequency of the output signal FOUT to a target frequency, during a fine tuning (or a micro-tuning) operation of the digital phase-locked loop 100. For example, the variable capacitance controller 150 may provide a pulse signal to some capacitor banks that replace varactors among the plurality of capacitor banks, and some capacitor banks may provide capacitors for a period of time corresponding to a duty ratio of the pulse signal. Accordingly, an average capacitance during one cycle of the pulse signal may be reflected in the combined capacitance of the digitally controlled oscillator 140.

The divider 160 may output the feedback signal FFEED by dividing the output signal FOUT. In one or more embodiments, the divider 160 may output the k-times feedback signal kFFEED.

The digital phase-locked loop 100 (or digital PLL) may achieve a small area by implementing a loop filter, which is a passive element having a large area, as a digital element. Also, the digital phase-locked loop 100 may be process-insensitive due to being robust to pole/zero variation, leakage, and noise in the loop filter. Also, the digital phase-locked loop 100 may have a short turnaround time (TAT) due to ease of testing, calibration, and the like.

According to one or more of the embodiments described above, the effect of improving power supply rejection ratio (PSRR) characteristics, the effect of improving ultra-low jitter, the effect of improving frequency drift due to changes in temperature, and the effect of improving the quality of service (QoS) of a digitally controlled oscillator or the quality factor Q of an LC tank may be achieved.

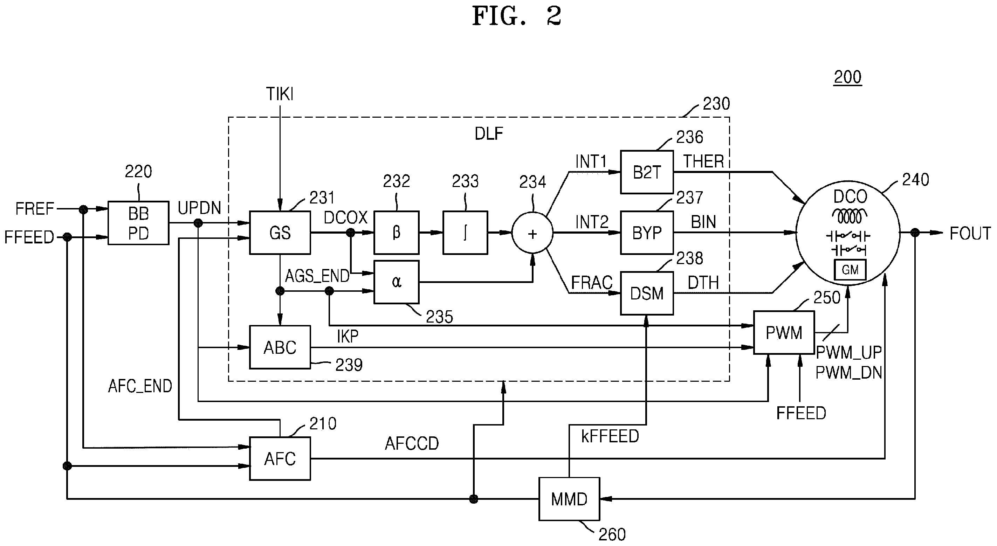

FIG. 2 is a block diagram of a digital phase-locked loop 200 according to one or more embodiments.

Referring to FIG. 2, the digital phase-locked loop 200 may include an automatic frequency calibration (AFC) 210 (e.g. an automatic frequency calibration circuit), a bang-bang phase detector (BBPD) 220, a digital loop filter (DLF) 230, a digitally-controlled oscillator (DCO) 240, a pulse width modulation (PWM) 250 (e.g. a pulse width modulation circuit), and a multi-modulus divider (MMD) 260.

The AFC 210 may correspond to one example of the automatic frequency calibration 110 of FIG. 1. Based on a reference signal FREF and a feedback signal FFEED, the AFC 210 may output a frequency-corrected signal AFCCD that includes digital code for coarse-tuning the output frequency of an output signal FOUT. For example, the output signal FOUT matched to a target signal may be M times the reference signal FREF (where M is an integer greater than or equal to 2). The AFC 210 may compare the frequency of the feedback signal FFEED with the frequency of the reference signal FREF at every reference cycle (e.g., 8 cycles) of the reference signal FREF and may adjust the output frequency of the DCO 240 based on the comparison result. For example, when the phase of the feedback signal FFEED lags behind the phase of the reference signal FREF (i.e., when the feedback signal FFEED is slower than the reference signal FREF), the AFC 210 may output a frequency-corrected signal AFCCD for increasing the output frequency of the DCO 240. For example, when the phase of the feedback signal FFEED leads the phase of the reference signal FREF (i.e., when the feedback signal FFEED is faster than the reference signal FREF), the AFC 210 may output a frequency-corrected signal AFCCD for decreasing the output frequency of the DCO 240. The AFC 210 may change a code value of the frequency-corrected signal AFCCD according to a binary search method in which code is sequentially changed from a most significant bit (MSB) to a least significant bit (LSB). In one or more embodiments, the AFC 210 may use the feedback signal FFEED to sample the reference signal FREF and use the sampled values (e.g., 0 or 1) to determine a correlation between edges of both of the feedback signal FFEED and the reference signal FREF. According to the embodiments described above, an error in the comparison between the edges may be reduced by the accumulated time of reference cycles. The AFC 210 may determine to decrease the combined capacitance inside the DCO 240 so that the output frequency of the output signal FOUT is increased, and may decrease the value of the digital code of the frequency-corrected signal AFCCD. The AFC 210 may determine to increase the combined capacitance inside the DCO 240 so that the output frequency of the output signal FOUT is decreased, and may increase the value of the digital code of the frequency-corrected signal AFCCD. In an embodiment, the AFC 210 may sequentially perform six times of comparing the sampled values to output the frequency-corrected signal AFCCD including 6 bits of code. After the six comparison operations are completed, the AFC 210 may change a logic level of a first enable signal AFC_END from a first logic level to a second logic level. For example, the first logic level of the first enable signal AFC_END may represent a logic low level, and the second logic level of the first enable signal AFC_END may represent a logic high level. However, embodiments are not limited to examples described above.

The BBPD 220 may correspond to one example of the phase detector 120 of FIG. 1. Based on the reference signal FREF and the feedback signal FFEED, the BBPD 220 may output an up-down signal UPDN. The up-down signal UPDN may include a signal that represents the comparison result between the phase of the reference signal FREF and the phase of the feedback signal FFEED. For example, when the phase of the feedback signal FFEED leads the phase of the reference signal FREF, the up-down signal UPDN may have a first logic level representing "down." When the phase of the feedback signal FFEED lags behind the phase of the reference signal FREF, the up-down signal UPDN may have a second logic level representing "up." For example, the first logic level of the up-down signal UPDN may represent a logic low level, and the second logic level of the up-down signal UPDN may represent a logic high level.

The DLF 230 may correspond to the digital loop filter 130 of FIG. 1. The DLF 230 may include a gate shifter (GS) 231, an integral gain operator 232, an integrator 233, an adder (or an accumulator) 234, a proportional gain operator 235, a binary to thermometer (B2T) decoder 236, a bypass circuit 237, a delta-sigma modulator (DSM) 238, and an adaptive bandwidth calibration (ABC) 239. In one or more embodiments, the GS 231, the integral gain operator 232, the integrator 233, the adder 234, the proportional gain operator 235, the B2T decoder 236, the bypass circuit 237, and the ABC 239 may each operate in synchronization with the feedback signal FFEED. The DSM 238 may operate in synchronization with a k-times feedback signal kFFEED.

The GS 231 may be enabled in response to a second logic level of a first enable signal AFC_END of the AFC 210. The GS 231 may receive a target gain signal TIKI that includes digital code representing a target loop gain. The target gain signal TIKI may be generated by circuitry (e.g. a core or the like) that exists outside of the digital phase-locked loop 200. During a gear-shifting operation, the GS 231 may sequentially change a loop gain from an initial loop gain (e.g., the maximum loop gain) to a target loop gain based on the up-down signal UPDN. For example, whenever the logic level of the up-down signal UPDN changes from the first logic level to the second logic level or from the second logic level to the first logic level, the digital code representing the value of the loop gain may change. After the gear-shifting operation, the GS 231 may change a logic level of a second enable signal AGS_END from a first logic level (e.g., a logic low level) to a second logic level (e.g., a logic high level).

The GS 231 may output a first control signal DCOX including digital code based on the logic level of the target loop gain and the up-down signal UPDN. For example, the first control signal DCOX may include digital code of 19 bits, but embodiments are not limited to the examples described above. For example, when the phase of the feedback signal FFEED is faster than the phase of the reference signal FREF, the logic level of the up-down signal UPDN may have a first logic level. Since the output frequency has to decrease, the combined capacitance inside the DCO 240 may increase. The GS 231 may increase the value of digital code to increase the capacitance inside the DCO 240. When the phase of the feedback signal FFEED is slower than the phase of the reference signal FREF, the logic level of the up-down signal UPDN may have a second logic level. Since the output frequency has to increase, the combined capacitance inside the DCO 240 may decrease. The GS 231 may decrease the value of digital code to decrease the capacitance inside the DCO 240.

The integral gain operator 232 may add a value of an integral gain Ki(β) to or subtract a value of the integral gain Ki(β) from a value of the digital code of the first control signal DCOX. The integrator 233 may integrate the value of the signal computed by the integral gain operator 232. The proportional gain operator 235 may add a value of a proportional gain Kp(α) to or subtract a value of the proportional gain Kp(α) from a value of the digital code of the first control signal DCOX. When the logic level of the second enable signal AGS_END changes from the first logic level to the second logic level, the value of the proportional gain Kp(α) may be zero. The adder 234 may add the value of an integral path (e.g., the integral gain operator 232 and the integrator 233) to the value of a proportional path (e.g., the proportional gain operator 235), and may output a second control signal that includes digital code representing the summed value. For example, the second control signal may include digital code of 19 bits, but embodiments are not limited to the examples described above. The second control signal may include a first upper bit signal INT1, a second upper bit signal INT2, and a lower bit signal FRAC. For example, when the second control signal has 19 bits (e.g., [18:0]), the lower bit signal FRAC may have 10 bits (e.g., FRAC[9:0]), the second upper bit signal INT2 may have 3 bits (e.g., INT[2:0]), and the first upper bit signal INT1 may have 6 bits (e.g., INT[8:3]). Accordingly, the first upper bit signal INT1 may include one or more of the most significant bits from the second control signal, the lower bit signal FRAC may comprise one or more of the least significant bits from the second control signal, and the second upper bit signal INT2 may comprise one or more remaining bits from the second control signal.

The B2T decoder 236 may decode the digital code of the first upper bit signal INT1 into a thermometer code and may output a thermometer signal THER including the thermometer code. The bypass circuit 237 may bypass the second upper bit signal INT2 and output a bypass signal BIN including the bypassed digital code. The DSM 238 may output a dithering signal DTH in response to a rising edge of a k-times feedback signal kFFEED, as the value of the digital code of the lower bit signal FRAC overflows. The dithering signal DTH may be a 1-bit signal that triggers a dithering operation for the DCO 240. For example, when the value of the digital code in the lower bit signal FRAC of 10 bits is "1111111111" and the value of 1b is increased (i.e., when the lower bit signal FRAC is carried to 11 bits), a pulse signal having a duty ratio may be output as the dithering signal DTH. However, embodiments are not limited to the examples described above. The DSM 238 may improve resolution by dithering a 1 LSB capacitor bank and thus minimize a quantization error. When the DSM 238 operates in response to the rising edge of the k-times feedback signal kFFEED, a quantization noise level may be reduced, and the quantization error may be less influential. The ABC 239 may be enabled in response to the second logic level of the second enable signal AGS_END. The ABC 239 may adjust a gain of the PWM 250 for an optimal bandwidth (e.g., a range over which an output frequency varies) in which a value of jitter is minimized. The ABC 239 may output an adjustment signal IKP based on the up-down signal UPDN. The adjustment signal IKP includes a signal for adjusting the gain of the PWM 250 and may include digital code that adjusts a duty ratio for a first period corresponding to one cycle of the feedback signal FFEED.

The DCO 240 may correspond to the digitally controlled oscillator 140 of FIG. 1. The DCO 240 may include an inductor, a plurality of capacitor bank circuits, and a negative voltage-current converter (e.g., a negative GM cell). The plurality of capacitor bank circuits may include capacitor bank circuits that receive first and second signals PWM_UP and PWM_DN of the PWM 250, and the capacitor bank circuit may change a first capacitance based on the first and second signals PWM_UP and PWM_DN. The negative voltage-current converter may compensate for a resistive component in an LC tank to achieve oscillation conditions. The DCO 240 exhibits excellent noise performance for improving ultra-low jitter, compared to a ring oscillator.

The PWM 250 may correspond to one example of the variable capacitance controller 150 of FIG. 1. Based on the feedback signal FFEED, the adjustment signal IKP, and the up-down signal UPDN, the PWM 250 may output the first signal PWM_DN or the second signal PWM_UP having a duty ratio corresponding to an adjustment signal. The signal having a duty ratio of a certain logic level among the first signal PWM_DN and the second signal PWM_UP may be determined according to the logic level of the up-down signal UPDN. For example, when the up-down signal UPDN is at the first logic level, the first signal PWM_DN may have the duty ratio of the specific logic level. When the up-down signal UPDN is at the second logic level, the second signal PWM_UP may have the duty ratio of the specific logic level. The first and second signals PWM_UP and PWM_DN may be included in capacitance control signals.

In one or more embodiments, the PWM 250 may detect the logic level of the up-down signal UPDN, in response to a falling edge of the feedback signal FFEED. In response to a rising edge of the feedback signal FFEED, the PWM 250 may output, as the capacitance control signal, a pulse signal for shifting the phase of the output signal FOUT according to the logic level of the up-down signal UPDN.

The MMD 260 may correspond to one example of the divider 160 of FIG. 1.

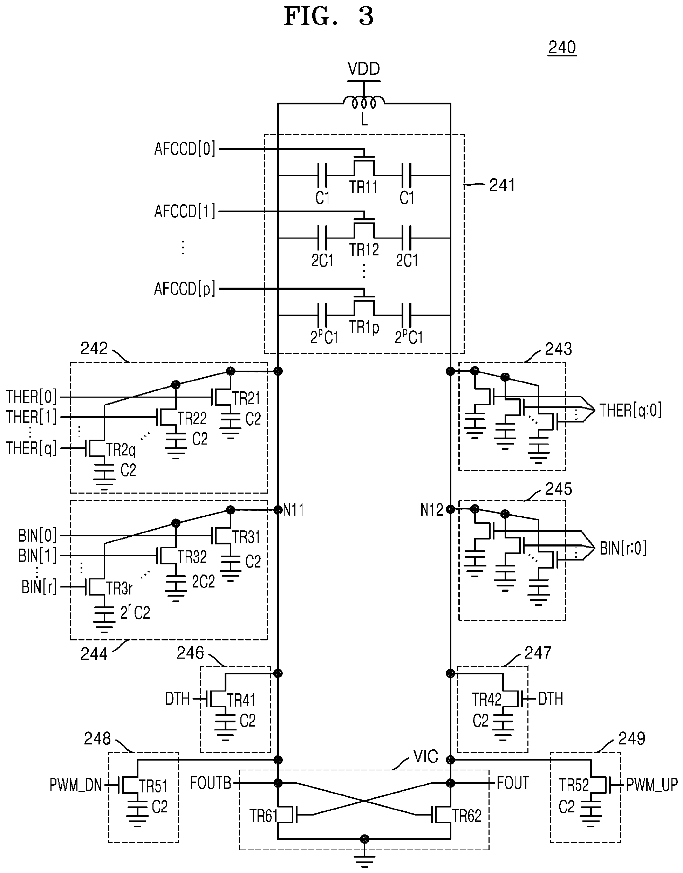

FIG. 3 is a circuit diagram of the DCO 240 according to one or more embodiments.

Referring to FIG. 3, the DCO 240 may include an inductor L, a plurality of capacitor bank circuits 241 to 249, and a negative voltage-current converter VIC.

The inductor L may be connected to a first node N11 and a second node N12. The inductor L may be connected between the first node N11 and the second node N12. The inductor L may have inductance.

The capacitor bank circuit 241 may set capacitance based on frequency-corrected signals AFCCD[p:0] during a coarse tuning operation, and may provide the capacitance after the coarse tuning operation is completed. The frequency-corrected signals AFCCD[p:0] may include digital code of p+1 bits, where p is an integer that is greater than or equal to 1. The capacitor bank circuit 241 may include a plurality of capacitor banks connected to the first node N11 and the second node N12. The capacitor banks may be connected between the first node N11 and the second node 12. The capacitor banks may be connected in parallel to each other. The number of capacitor banks included in the capacitor bank circuit 241 may correspond to the number of pieces of digital code in the frequency-corrected signals AFCCD[p:0]. Each capacitor bank in the capacitor bank circuit 241 may include two capacitors and one transistor located between the two capacitors. At the gate electrodes of the corresponding transistors, the digital code of the corresponding frequency-corrected signals AFCCD[p:0] may be received. For example, the gate electrode of a transistor TR11 may receive a frequency-corrected signal AFCCD[0], the gate electrode of a transistor TR12 may receive a frequency-corrected signal AFCCD[1], and the gate electrode of a transistor TR1p may receive a frequency-corrected signal AFCCD[p]. The capacitance of the capacitors in the plurality of capacitor banks may be C1, 2C1, ..., and 2^{p}C1. The capacitance of the capacitors in an n^{th} bank may be 2ⁿC1, where n is an integer that is greater than or equal to 0 and less than or equal to p.

The capacitor bank circuits 242 to 245 may set capacitance based on thermometer signals THER[q:0] and bypass signals BIN[r:0] during a gear-shifting operation, and may provide the capacitance after the gear-shifting operation is completed.

The capacitor bank circuits 242 and 243 may receive the thermometer signals THER[q:0] including digital code of q+1 bits. The capacitor bank circuit 242 may include a plurality of capacitor banks connected to the first node N11 (e.g. between the first node N11 and ground). The number of capacitor banks included in the capacitor bank circuit 242 may correspond to the number of pieces of digital code in the thermometer signals THER[q:0]. Each capacitor bank in the capacitor bank circuit 242 may include one capacitor and one transistor that are connected in series to each other (e.g. between the first node N11 and ground). The capacitor banks may be connected in parallel to each other. For example, the gate electrode of a transistor TR21 may receive a thermometer signal THER[0], the gate electrode of a transistor TR22 may receive a thermometer signal THER[1], and the gate electrode of a transistor TR2q may receive a thermometer signal THER[q]. Capacitors in the plurality of capacitor banks may all have the same capacitance, C2. The capacitance C2 may be less than the capacitance C1. The capacitor bank circuit 243 is connected to the second node N12 and may include a circuit the same as (e.g. symmetrical to) the capacitor bank circuit 242.

The capacitor bank circuit 244 may include a plurality of capacitor banks, each including one capacitor and one transistor that are connected in series to each other at the first node N11(e.g. between the first node N11 and ground). The capacitor banks may be connected in parallel to each other. The capacitance of the capacitors in the plurality of capacitor banks may be C2, 2C2, ..., and 2^{r}C2. The capacitance of the capacitors in an n^{th} bank may be 2ⁿC2, where n is an integer that is greater than or equal to 0 and less than or equal to r. The capacitor bank circuit 245 is connected to the second node N12 and may include a circuit the same as (e.g. symmetrical to) the capacitor bank circuit 244.

The capacitor bank circuits 246 and 247 may provide capacitance based on a dithering signal DTH during a fine tuning operation. The capacitor bank circuit 246 may include a capacitor bank including one capacitor and one transistor that are connected in series to each other at the first node N11 (e.g. between the first node N11 and ground). The capacitor in the capacitor bank circuit 246 may have a capacitance of C2. The capacitor bank circuit 247 is connected to the second node N12 and may include a circuit the same as (e.g. symmetrical to) the capacitor bank circuit 246. The gate electrodes of transistors TR41 and TR42 included in the capacitor bank circuits 246 and 247, respectively, may receive the dithering signal DTH. When the logic level of the dithering signal DTH is at a second logic level, the transistors TR41 and TR42 are turned on. Also, capacitors in the capacitor bank circuits 246 and 247 may be connected to the first and second nodes N11 and N12 to provide the capacitance of capacitors. When the logic level of the dithering signal DTH is at a first logic level, the transistors TR41 and TR42 are turned off.

The capacitor bank circuit 248 may provide capacitance based on a first signal PWM_DN after a phase lock operation. The capacitor bank circuit 248 may be connected between one end of the inductor L and ground, and may include a capacitor bank that provides first capacitance in response to an activation level of the first signal PWM_DN. The capacitor bank may include one capacitor and one transistor that are connected in series to each other at the first node N11. A transistor TR51 is turned on in response to a second logic level of the first signal PWM_DN. As a capacitor in the capacitor bank circuit 248 is connected to the first node N11 via the turned-on transistor TR51, the first capacitance may be provided. The first capacitance may be C2.

The capacitor bank circuit 249 may provide capacitance based on a second signal PWM_UP after the phase lock operation. The capacitor bank circuit 249 may be connected between the other end of the inductor L and the ground, and may include a capacitor bank that provides the first capacitance in response to an activation level of the second signal PWM_UP. The capacitor bank may include one capacitor and one transistor that are connected in series to each other at the second node N12. A transistor TR52 is turned on in response to a second logic level of the second signal PWM_UP. As a capacitor in the capacitor bank circuit 249 is connected to the second node N12 via the turned-on transistor TR52, the capacitance C2 of the capacitor may be provided.

The transistors TR11 to TR1p, TR21 to TR2q, TR31 to TR3r, TR41, TR42, TR51, and TR52 shown in FIG. 3 may be implemented as N-type metal-oxide-semiconductor (NMOS) transistors and may have different sizes. However, the inventive concept is not limited to the embodiment shown in FIG. 2.

The negative voltage-current converter VIC may include transistors TR61 and TR62. The transistor TR61 may be connected between the first node N11 and the ground, and a gate electrode of the transistor TR61 may be connected to the second node N12. An inverted output signal FOUTB may be output from the first node N11. The transistor TR62 may be connected between the second node N12 and the ground, and a gate electrode of the transistor TR62 may be connected to the first node N11. An output signal FOUT may be output from the second node N12.

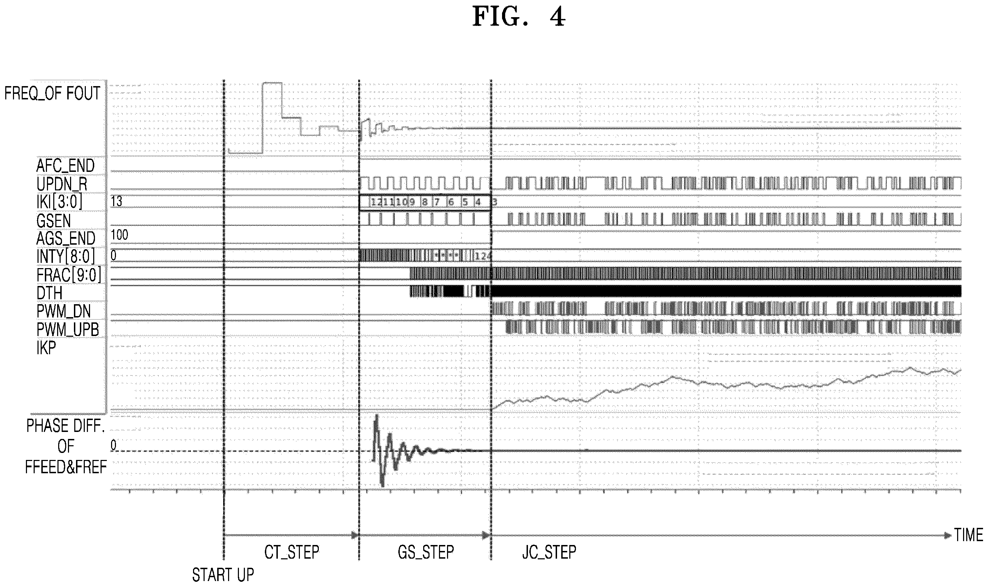

FIG. 4 is a timing chart of signals in the digital phase-locked loop 200 according to one or more embodiments.

Referring to FIG. 4, the digital phase-locked loop 200 may effectively eliminate phase errors, which accumulate in the DCO 240, by using the capacitor bank that receives pulse signals having variable pulse widths, thereby achieving low jitter. The digital phase-locked loop 200 may perform, from a start time START UP, a coarse tuning operation CT_STEP, a gear-shifting operation GS_STEP (or a phase lock operation), and a jitter-cleaning operation JC_STEP.

During the coarse tuning operation CT_STEP, an output frequency FREQ_OF FOUT of an output signal FOUT may be tuned such that the output frequency FREQ_OF FOUT is within a certain (e.g. target) frequency range. For example, when the output frequency FREQ_OF FOUT of the output signal FOUT is less than a target frequency, the output frequency FREQ_OF FOUT of the output signal FOUT may increase according to an output value of the AFC 210. Similarly, when the output frequency FREQ_OF FOUT of the output signal FOUT is greater than a target frequency, the output frequency FREQ_OF FOUT of the output signal FOUT may decrease according to an output value of the AFC 210. When the output frequency FREQ_OF FOUT of the output signal FOUT is within the certain frequency range, the coarse tuning operation CT_STEP is terminated, and the logic level of the first enable signal AFC_END may change from a logic low level to a logic high level.

In order to reliably lock the output frequency of the output signal FOUT to the target frequency, it is required to prevent cycle slip. A lock-in-range, which represents a range over which a frequency is locked without cycle slip, may be proportional to the loop gain of the digital phase-locked loop 200. Therefore, the gear-shifting operation GS_STEP is performed in which an initial loop gain is set large to reliably correct even relatively large phase differences, and then the loop gain is sequentially reduced from the initial loop gain to the target loop gain. In an embodiment, during the gear-shifting operation GS_STEP, each time the logic level of a first sampling signal UPDN_R changes, a value IKI[3:0] of loop gain may sequentially decrease from an initial value (e.g., 13) to a target value (e.g., 3). The first sampling signal UPDN_R may correspond to the up-down signal UPDN. The target value may be set by the target gain signal TIKI as described above with reference to FIG. 2. For example, according to the logic level of the first sampling signal UPDN_R, the value of each of an upper bit signal INTY[8:0] and a lower bit signal FRAC[9:0] may change, and the dithering signal DTH may be generated. Accordingly, the output frequency and phase of the output signal FOUT may be tuned. When the logic level of the first sampling signal UPDN_R changes from the first logic level to the second logic level (or from the second logic level to the first logic level), an internal enable signal GSEN may occur as a flag signal, and the value IKI[3:0] of loop gain may be reduced by one in response to the internal enable signal GSEN. The upper bit signals INTY[8:0] and the lower bit signals FRAC[9:0] may be included in a second control signal having digital code of 19 bits, for example, as described above with reference to FIG. 2. For example, some signals INTY[8:3] of the upper bit signals INTY[8:0] may correspond to the first upper bit signal INT1, some other signals INTY[2:0] of the upper bit signals INTY[8:0] may correspond to the second upper bit signal INT2, and the lower bit signals FRAC[9:0] may correspond to the lower bit signal FRAC. A carry bit, which occurs when the bit signals of FRAC[9:0] accumulate in the DSM 238, generates a 1-bit dithering signal (1-bit DTH signal). A phase difference (see "PHASE DIFF. OF FFEED&FREF" of Fig. 4) taken between the reference signal FREF and the feedback signal FFEED may gradually approach zero. When the value IKI[3:0] of loop gain is set to the target value, the values of upper bit signals INTY[8:0] are locked, the gear-shifting operation GS_STEP is terminated, and the logic level of the second enable signal AGS_END may change from the logic low level to the logic high level.

During the jitter-cleaning operation JC_STEP, according to the logic level of the first sampling signal UPDN_R, the first signal PWM_DN and a second inverted signal PWM_UPB may be generated. Accordingly, the output frequency and phase of the output signal FOUT may be tuned. The second inverted signal PWM_UPB may represent a signal that is formed by inverting the second signal PWM_UP. When the logic level of the first sampling signal UPDN_R is at the logic low level, the first signal PWM_DN may have the duty ratio of the logic high level, and the second inverted signal PWM_UPB may remain at the logic high level. When the logic level of the first sampling signal UPDN_R is at the logic high level, the first signal PWM_DN may remain at the logic low level, and the second inverted signal PWM_UPB may have the duty ratio of the logic high level. The duty ratio of the first signal PWM_DN or the second inverted signal PWM_UPB may change according to the value of the adjustment signal IKP. After the gear-shifting operation GS_STEP, the values of the upper bit signals INTY[8:0] may remain unchanged, and the values of the lower bit signals FRAC[9:0] may change very little. This may mean that the change in output frequency of the DCO 240 is small.

The jitter-cleaning operation JC_STEP may be referred to as an operation of effectively removing errors that have accumulated in the DCO 240, at each period of the reference signal FREF after the gear-shifting operation GS_STEP. Embodiments for tuning the output frequency and phase of the output signal FOUT during the jitter-cleaning operation JC_STEP are described below.

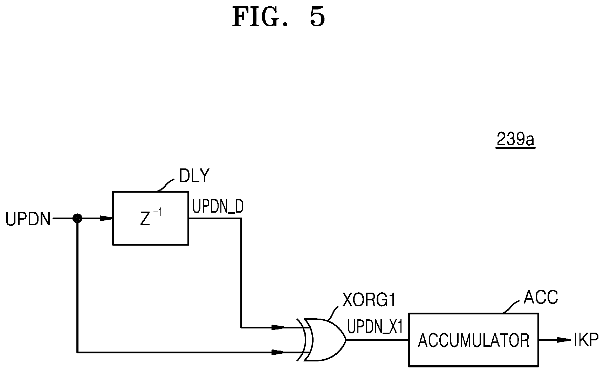

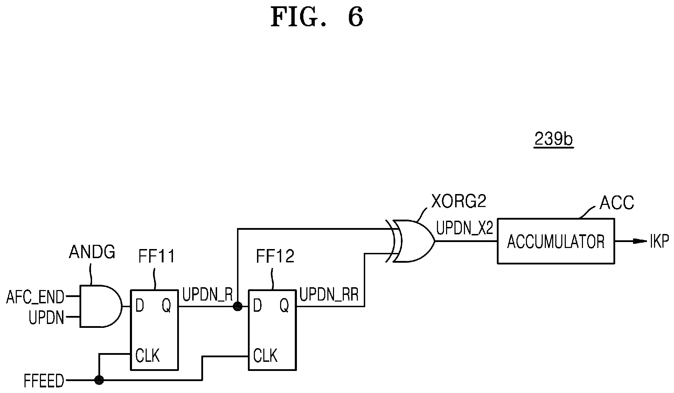

FIGS. 5 and 6 are block diagrams of ABCs 239a and 239b according to embodiments.

Referring to FIG. 5, the ABC 239a may include a delay DLY, an exclusive logical sum operator XORG1, and an accumulator ACC.

The delay DLY may delay the up-down signal UPDN and may output a delayed up-down signal UPDN_D. For example, the delayed up-down signal UPDN_D may represent a signal that is one cycle delayed from the up-down signal UPDN.

The exclusive logical sum operator XORG1 may perform an exclusive logical sum operation (e.g. an exclusive OR (XOR) operation) between the logic level of the up-down signal UPDN and the logic level of the delayed up-down signal UPDN_D, and may output an operation result signal UPDN_X1 representing the result of the exclusive logical sum operation. The term "exclusive logical sum operation" may refer to an exclusive OR (XOR) operation, which may be implemented through an XOR gate. When the logic level of the up-down signal UPDN is equal to the logic level of the delayed up-down signal UPDN_D, the logic level of the operation result signal UPDN_X1 may be at a logic low level. When the logic level of the up-down signal UPDN is different from the logic level of the delayed up-down signal UPDN_D, the logic level of the operation result signal UPDN_X1 may be at a logic high level.

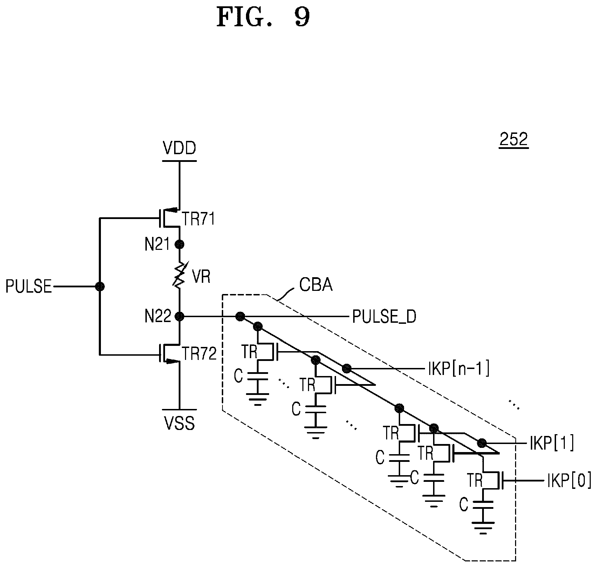

The accumulator ACC may cumulatively add up operation result signals UPDN_X1, change the value of the digital code according to the accumulated result, and output an adjustment signal IKP. The accumulated result may correspond, for example, to a value of the gain of the variable capacitance controller 150 (e.g., the PWM 250) in digital code of 8 bits. The time at which a switch (e.g., a transistor TR) of a capacitor bank is turned on may be adjusted according to the adjustment signal IKP, which is described below with reference to FIG. 9.

Referring to FIG. 6, the ABC 239b may include a logical product operator ANDG, a first sampler FF11, a second sampler FF12, an exclusive logical sum operator XORG2, and an accumulator ACC.

The logical product operator ANDG may perform a logical product operation between the logic level of the first enable signal AFC_END and the logic level of the up-down signal UPDN, and may provide the result of the logical product operation to the first sampler FF11. The term "logical product operation" may refer to a logical AND operation, which may be implemented through an AND gate. According to one or more embodiments, in the gear-shifting operation GS_STEP and the jitter-cleaning operation JC_STEP, the logic level of the first enable signal AFC_END may be at a second logic level (e.g., a logic high level). In the gear-shifting operation GS_STEP and the jitter-cleaning operation JC_STEP, the logical product operator ANDG may provide the logic level of the up-down signal UPDN to the first sampler FF11.

The first sampler FF11 may sample the result of the logical product operation of the logical product operator ANDG in response to an edge of a feedback signal FFEED, and may output a first sampling signal UPDN_R. According to one or more embodiments, in the gear-shifting operation GS_STEP and the jitter-cleaning operation JC_STEP, the first sampler FF11 may sample the up-down signal UPDN in response to a rising edge of the feedback signal FFEED.

In response to the edge (e.g., the rising edge) of the feedback signal FFEED, the second sampler FF12 may sample the first sampling signal UPDN_R and output a second sampling signal UPDN_RR.

As a non-limiting example, the first and second samplers FF11 and FF12 may be implemented as flip-flops.

The exclusive logical sum operator XORG2 may perform an exclusive logical sum operation between the logic levels of the first and second sampling signals UPDN_R and UPDN_RR, and may output an operation result signal UPDN_X2 representing the result of the exclusive logical sum operation.

The accumulator ACC may change the value of the digital code of the adjustment signal IKP based on the operation result signal UPDN_X2 and output the adjustment signal IKP. In one or more embodiments, when the logic levels of up-down signals UPDN are continued at the same logic level, the logic level of the operation result signal UPDN_X2 may be at a first logic level. In this case, the accumulator ACC may determine that the gain of the PWM 250 is small, and may increase the gain of the PWM 250 by increasing the value of the adjustment signal IKP. When the logic levels of the up-down signals UPDN are continuously changing, the logic level of the operation result signal UPDN_X2 may be at a second logic level. In this case, the accumulator ACC may determine that the gain of the PWM 250 is large, and may decrease the gain of the PWM 250 by decreasing the value of the adjustment signal IKP.

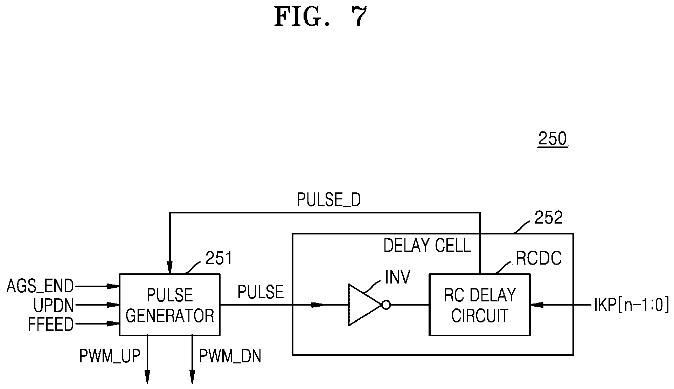

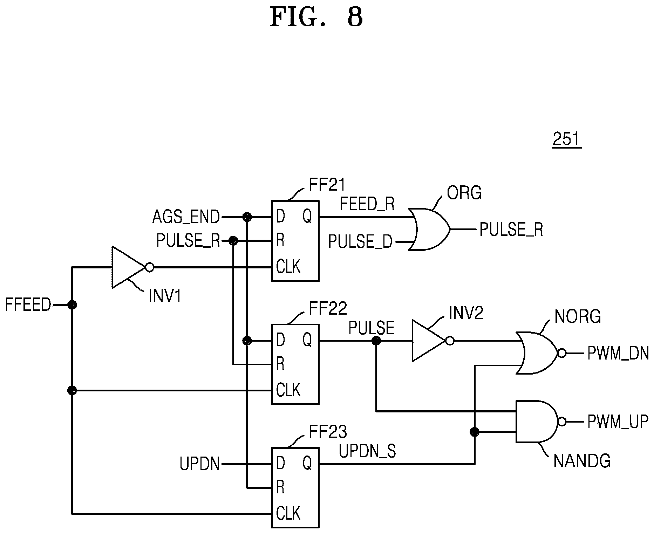

FIG. 7 is a block diagram of a PWM 250 according to one or more embodiments, FIG. 8 is a circuit diagram of a pulse generator 251 according to one or more embodiments, and FIG. 9 is a circuit diagram of a delay cell 252 according to one or more embodiments.

Referring to FIGS. 7 to 9, a PWM 250 as an example of a variable capacitance controller may include a pulse generator 251 and a delay cell 252.

The pulse generator 251 may receive a second enable signal AGS_END, an up-down signal UPDN, and a feedback signal FFEED. The pulse generator 251 may sample the second enable signal AGS_END and the up-down signal UPDN in response to an edge of the feedback signal FFEED. The pulse generator 251 may output, as capacitance control signals, first and second signals PWM_UP and PWM_DN based on a sampled enable signal PULSE and a sampled up-down signal UPDN_S. The pulse generator 251 may be reset in response to a delay signal PULSE_D.

Referring to FIG. 8, in an embodiment, the pulse generator 251 may include first and second inverters INV1 and INV2, first to third flip-flops FF21, FF22, and FF23, a logical sum operator ORG, a negative logical sum operator NORG, and a negative logical product operator NANDG. The logical sum operator may be an OR gate. The negative logical sum operator may be a NOR gate. The negative logical product operator may be a NAND gate.

The first inverter INV1 may invert the feedback signal FFEED and provide the inverted feedback signal to the first flip-flop FF21.

The first flip-flop FF21 may sample the second enable signal AGS_END in response to an edge of the inverted feedback signal. The first flip-flop FF21 may output a feedback reset signal FEED_R. The first flip-flop FF21 may be reset in response to a reset signal PULSE_R.

The second flip-flop FF22 may sample the second enable signal AGS_END in response to the edge of the feedback signal FFEED. The second flip-flop FF22 may output the sampled enable signal PULSE. The second flip-flop FF22 may be reset in response to the reset signal PULSE_R.

In response to the edge of the feedback signal FFEED, the third flip-flop FF23 may sample the up-down signal UPDN and output the sampled up-down signal UPDN_S. The third flip-flop FF23 may be reset in response to the second enable signal AGS_END. According to one or more embodiments, the second enable signal AGS_END may remain at a second logic level (e.g., a logic high level) in the jitter-cleaning operation JC_STEP. Therefore, the third flip-flop FF23 may remain reset in a fine tuning operation FT_STEP, and the logic level of the sampled up-down signal UPDN_S may remain at a first logic level.

The logical sum operator ORG may perform a logical sum operation (e.g. a logical OR operation) between a logic level of the feedback reset signal FEED_R and a logic level of the delay signal PULSE_D, and may output the reset signal PULSE_R.

The second inverter INV2 may invert the sampled enable signal PULSE and provide the inverted enable signal to the negative logical sum operator NORG.

The negative logical sum operator NORG may perform a negative logical sum operation (e.g. a logical NOR operation) between the logic level of the sampled up-down signal UPDN_S and the logic level of the inverted enable signal. The negative logical sum operator NORG may output a first signal PWM_DN that causes the phase lagging of an output signal FOUT.

The negative logical product operator NANDG may perform a negative logical product operation (e.g. a logical NAND operation) between the logic level of the sampled up-down signal UPDN_S and the logic level of the sampled enable signal PULSE. The negative logical product operator NANDG may output a second signal PWM_UP that causes the phase leading of the output signal FOUT.

The delay cell 252 may receive the sampled enable signal PULSE and adjustment signals IKP[n-1:0]. In one or more embodiments, the adjustment signals IKP[n-1:0] may include n-bit digital code. The delay cell 252 may determine a delay time for the sampled enable signal PULSE based on the adjustment signals IKP[n-1:0]. The delay cell 252 may output the delay signal PULSE_D by delaying the sampled enable signal PULSE by using the delay time.

In one or more embodiments, the delay cell 252 may include an inverter INV and an RC delay circuit RCDC. The inverter INV may invert the sampled enable signal. The RC delay circuit RCDC may represent a delay circuit that includes a variable resistor and a variable capacitor. The RC delay circuit RCDC may determine the amount of delay of the signal inverted by the inverter INV based on the digital code of the adjustment signals IKP[n-1:0], and may provide the delay signal PULSE_D to the pulse generator 251.

Referring to FIGS. 7 and 9, in one or more embodiments, the inverter INV of the delay cell 252 may include first and second transistors TR71 and TR72. The RC delay circuit RCDC of the delay cell 252 may include a variable resistor VR and a capacitor bank array CBA.

The first transistor TR71 of the inverter INV may transmit a supply voltage VDD to a first node N21, in response to a first logic level of the sampled enable signal PULSE.

The second transistor TR72 of the inverter INV may transmit a ground voltage of the ground to a second node N22, in response to a second logic level of the sampled enable signal PULSE. In one or more embodiments, the first transistor TR71 may be implemented as a P-type MOS (PMOS) transistor, and the second transistor TR72 may be implemented as an NMOS transistor.

The variable resistor VR of the RC delay circuit RCDC may be connected between the first node N21 and the second node N22. The resistance (or the resistance value) of the variable resistor VR may be set by circuitry (e.g. a core or the like) that exists outside of the digital phase-locked loop 200.

The capacitor bank array CBA of the RC delay circuit RCDC is connected between the second node N22 and the ground, and may provide second capacitance corresponding to the amount of delay based on the digital code. The capacitor bank array CBA may include a plurality of capacitor banks. Each capacitor bank in the capacitor bank array CBA may include one transistor and one capacitor. The adjustment signals IKP[n-1:0] may include digital code of n bits. The number of capacitor banks receiving upper bits of the digital code of n bits may be twice as many as the number of capacitor banks receiving lower bits of the digital code of n bits. For example, 128 capacitor banks may receive the adjustment signal IKP[n-1], 64 capacitor banks may receive the adjustment signal IKP[n-2], 2 capacitor banks may receive the adjustment signal IKP[1], and 1 capacitor bank may receive the adjustment signal IKP[0]. That is, with each successive bit, from the first bit of the adjustment signal IKP[0], the number of capacitor banks may double. However, embodiments are not limited to the examples described above. As the values of the digital code of the adjustment signals IKP[n-1:0] increase or decrease, the number of capacitor banks turned on in the capacitor bank array CBA may increase or decrease, and the amount of delay or the delay time due to the RC delay circuit RCDC may change. For example, as the values of the digital code of the adjustment signals IKP[n-1:0] increase, the number of capacitor banks turned on in the capacitor bank array CBA may increase, and the amount of delay or the delay time may increase. For example, as the values of the digital code of the adjustment signals IKP[n-1:0] decrease, the number of capacitor banks turned on in the capacitor bank array CBA may decrease, and the amount of delay or the delay time may decrease.

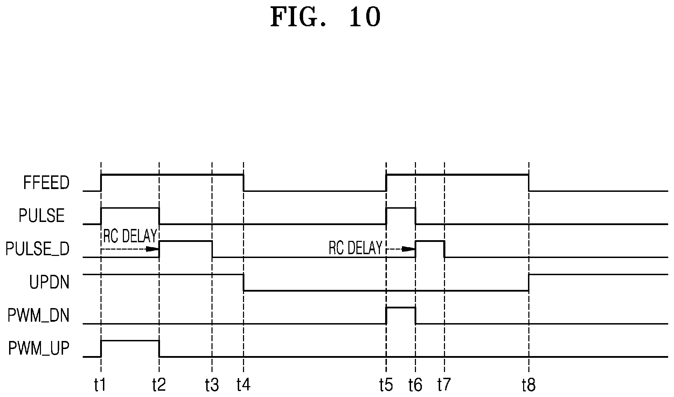

FIG. 10 is a timing chart of the signals denoted by reference signs FFEED, PULSE, PULSE_D, UPDN, PWM_UP, and PWM_DN shown in FIGS. 8 and 9. In FIG. 10, it is assumed that the first logic level is at a logic low level and the second logic level is at a logic high level.

Referring to FIGS. 8 to 10, it is assumed that: during a period from a first point in time t1 to a fourth point in time t4, the logic level of the up-down signal UPDN is at the second logic level; during a period from the fourth point in time t4 to an eighth point in time t8, the logic level of the up-down signal UPDN is at the first logic level; and starting from the eighth point in time t8, the logic level of the up-down signal UPDN changes from the first logic level to the second logic level.

In one or more embodiments, the logic level of the up-down signal UPDN may be detected in response to a falling edge of the feedback signal FFEED. After the falling edge of the feedback signal FFEED occurs, the first signal PWM_DN or the second signal PWM_UP may be output in the form of a pulse in response to a rising edge of the feedback signal FFEED. Accordingly, no glitch issues occur.

Although not shown, it is assumed that the logic level of the up-down signal UPDN is detected as the second logic level at the falling edge of the feedback signal FFEED before the first point in time t1.

At the first point in time t1, in response to the rising edge of the feedback signal FFEED, the logic level of the sampled enable signal PULSE may be at the second logic level. Accordingly, the logic level of the second signal PWM_UP may be at the second logic level.

As the rising edge of the sampled enable signal PULSE occurs, a rising edge of a delay signal PULSE_D delayed by the amount of a delay time RC DELAY may occur at the second point in time t2. In this case, the logic level of the reset signal PULSE_R becomes the second logic level, and the first and second flip-flops FF21 and FF22 may be reset. In this case, the logic level of the sampled enable signal PULSE may change from the second logic level to the first logic level.

At the third point in time t3, the logic level of the reset signal PULSE_R may change from the second logic level to the first logic level.

At the fourth point in time t4, the falling edge of the feedback signal FFEED may occur, and the logic level of the up-down signal UPDN may be detected. In this case, the logic level of the up-down signal UPDN may be at the first logic level. The frequency correction timing for causing the phase lagging of the output signal FOUT or reducing the output frequency of the output signal FOUT may be when the rising edge of the feedback signal FFEED occurs after the fourth point in time t4.

At the fifth point in time t5, the logic level of the sampled enable signal PULSE may change from the first logic level to the second logic level in response to the rising edge of the feedback signal FFEED, and accordingly, the logic level of the first signal PWM_DN may change from the first logic level to the second logic level.

The timings of the signals denoted by reference signs FFEED, PULSE, PULSE_D, UPDN, PWM_UP, and PWM_DN after the fifth point in time t5 (t6, t7 and t8) are similar to the timings of the signals denoted by reference signs FFEED, PULSE, PULSE_D, UPDN, PWM_UP, and PWM_DN from the second point in time t2 to the fourth point in time t4, and thus, descriptions thereof are omitted. Also, at the eighth point in time t8, the logic level of the up-down signal UPDN may be detected as the second logic level in response to the falling edge of the feedback signal FFEED. In this case, the timings of the signals denoted by reference signs FFEED, PULSE, PULSE_D, UPDN, PWM_UP, and PWM_DN may be similar to the timings of the signals denoted by reference signs FFEED, PULSE, PULSE_D, UPDN, PWM_UP, and PWM_DN from the first point in time t1 to the fourth point in time t4.

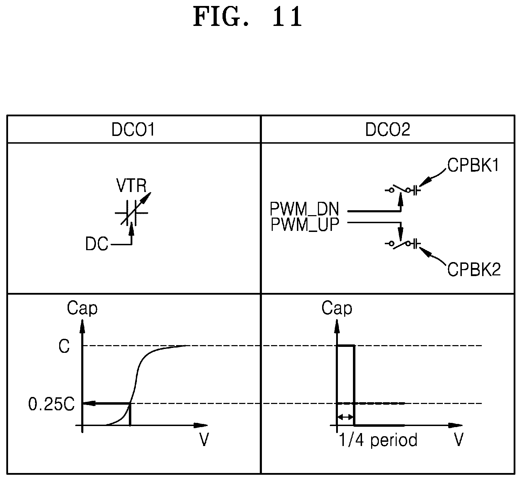

FIG. 11 is a diagram illustrating variable capacitance.

Referring to FIG. 11, a first DCO DCO1 may include a varactor VTR based on a MOSFET. The varactor VTR may change in capacitance in response to direct current voltage DC. As the value of the direct current voltage DC increases, the capacitance of the varactor VTR also increases and may converge to the maximum capacitance C. For example, in the voltage-capacitance graph shown in FIG. 11, the capacitance of the varactor VTR may be 0.25 C when the direct current voltage DC is at a certain value. When the input direct current voltage DC varies, the capacitance also varies, which may cause the output frequency of the first DCO DCO1 to vary. Therefore, the varactor VTR is susceptible to power supply noise or supply noise. The threshold voltage of the MOSFETs in the varactor VTR may vary with temperature, and thus, the capacitance may also vary. Therefore, the varactor VTR causes frequency drift according to the temperature. The quality factor according to the capacitor of the varactor VTR is lower than the quality factor according to a metal capacitor. In addition, the voltage-capacitance graph with nonlinearity characteristics is created by the varactor VTR. Therefore, the first DCO DCO1 has relatively large jitter sensitivity, is susceptible to changes in temperature, and has a low quality factor.

On the other hand, a second DCO DCO2 is included in the digital phase-locked loops 100 and 200 according to the one or more embodiments. The second DCO DCO2 may include first and second capacitor banks CPBK1 and CPBK2 instead of the varactor VTR of the first DCO DCO1. The first capacitor bank CPBK1 may receive a first signal PWM_DN, and the second capacitor bank CPBK2 may receive a second signal PWM_UP. When the first signal PWM_DN or the second signal PWM_UP in the form of a pulse occurs, a switch of a capacitor bank receiving the signal in the form of a pulse is turned on, and the capacitor bank may provide capacitance for a period corresponding to the pulse width. In this case, the capacitor bank receiving the signal in the form of a pulse may provide an average of the capacitance over 1 period of the pulse signal. In order to set the capacitance equal to the capacitance of the varactor VTR of 0.25 C, the first signal PWM_DN having a duty ratio of 0.25 (%) may be generated. In this case, the first capacitor bank CPBK1 may provide capacitance C through the turn-on of the switch during 1/4 period of 1 period of the first signal PWM_DN, and may not provide capacitance through the turn-off of the switch during 3/4 period of 1 period of the first signal PWM_DN. Therefore, the average of the capacitance of the first capacitor bank CPBK1 in an LC tank during 1 period of the first signal PWM_DN may be 0.25 C.

According to the embodiments described above, instead of a comparative example in which the output frequency is corrected by inputting the direct current voltage DC to the varactor VTR, the average capacitance in the LC tank is adjusted by adjusting the on-off time of the capacitor bank. Accordingly, the embodiments may have the effect of overcoming the limitations of the varactor VTR (e.g., a poor PSRR, drift in output frequency due to changes in temperature, limited low jitter performance, etc.).

The embodiments described above have the effect of significantly reducing the frequency error in the initial cycle of the feedback signal FFEED, thereby lowering the root mean square (RMS) jitter.

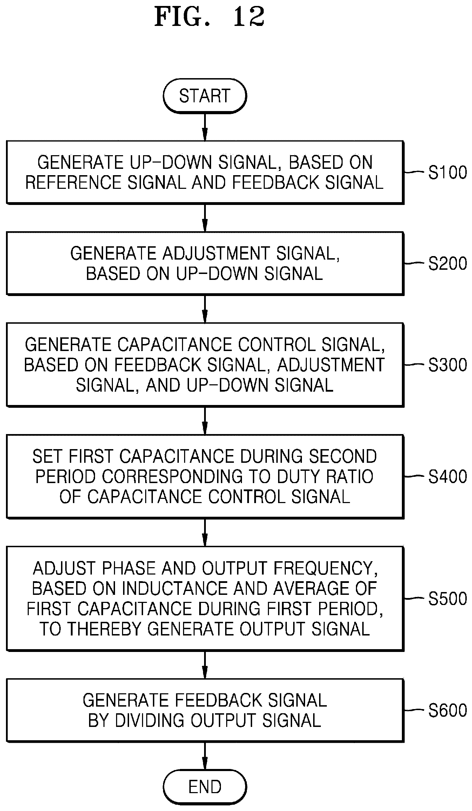

FIG. 12 is a flowchart illustrating a method of operating a digital phase-locked loop, according to one or more embodiments.

Referring to FIG. 12, in operation S100, the digital phase-locked loop may generate an up-down signal based on a reference signal and a feedback signal. The up-down signal may include a signal that represents the result of a comparison between the phase of the reference signal and the phase of the feedback signal. Operation S100 may be performed by the phase detector 120 of FIG. 1 and/or the BBPD 220 of FIG. 2.

In operation S200, the digital phase-locked loop may generate an adjustment signal including digital code based on the up-down signal. The adjustment signal may include a signal that adjusts the duty ratio for a first period corresponding to a period of the feedback signal. Operation S200 may be performed by the digital loop filter 130 of FIG. 1 and/or the ABC 239 of FIG. 2.

In operation S300, the digital phase-locked loop may generate a capacitance control signal having the duty ratio based on the feedback signal, the adjustment signal, and the up-down signal. Operation S300 may be performed by the variable capacitance controller 150 of FIG. 1 and/or the PWM 250 of FIG. 2.

In operation S400, the digital phase-locked loop may set first capacitance for a second period corresponding to the duty ratio of the capacitance control signal.

In operation S500, the digital phase-locked loop may set an output frequency based on the inductance and the average of the first capacitance during the first period and may then generate an output signal having the output frequency. Operation S400 and operation S500 may be performed by the digitally controlled oscillator 140 of FIG. 1 and/or the DCO 240 of FIG. 2.

In operation S600, the digital phase-locked loop may generate the feedback signal by dividing the output signal. Operation S600 may be performed by the divider 160 of FIG. 1 and/or the MMD 260 of FIG. 2.

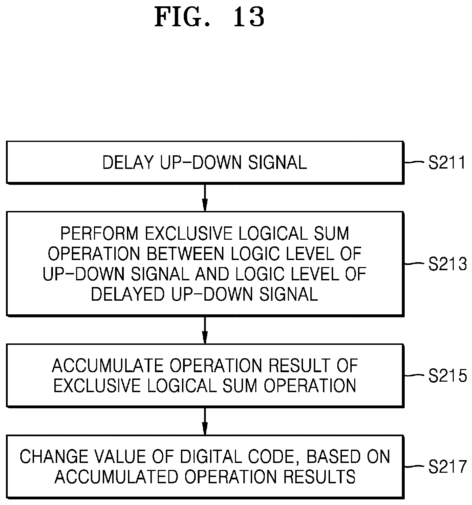

FIG. 13 is a flowchart illustrating one example of operation S200 of FIG. 12.

Referring to FIG. 13, operation S200 may include operation S211, operation S213, operation S215, and operation S217. Operation S211, operation S213, operation S215, and operation S217 may be performed by the ABC 239a of FIG. 5.

In operation S211, the digital phase-locked loop may delay the up-down signal. Operation S211 may be performed by the delay DLY of FIG. 5.

In operation S213, the digital phase-locked loop may perform an exclusive logical sum operation between the logic level of the up-down signal and the logic level of the delayed up-down signal. Operation S213 may be performed by the exclusive logical sum operator XORG1 of FIG. 5.

In operation S215, the digital phase-locked loop may accumulate operation results of the exclusive logical sum operation. In operation S217, the digital phase-locked loop may change the value of the digital code based on the accumulated operation results. Operation S215 and operation S217 may be performed by the accumulator ACC of FIG. 5.

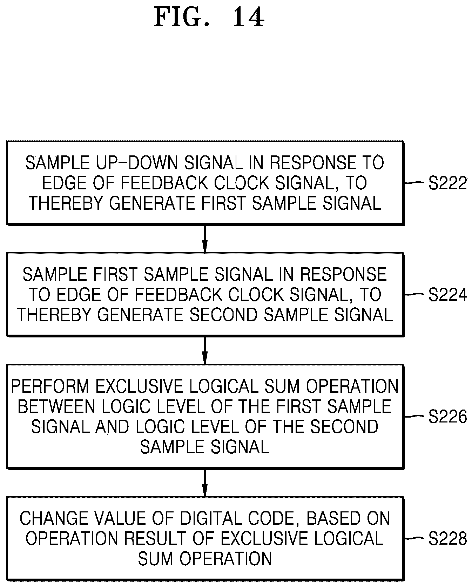

FIG. 14 is a flowchart illustrating another example of operation S200 of FIG. 12.

Referring to FIG. 14, operation S200 may include operation S222, operation S224, operation S226, and operation S228. Operation S222, operation S224, operation S226, and operation S228 may be performed by the ABC 239b of FIG. 6.

In operation S222, the digital phase-locked loop may sample the up-down signal in response to an edge of the feedback clock signal, thereby generating a first sampling signal. Operation S222 may be performed by the first sampler FF11 of FIG. 6.

In operation S224, the digital phase-locked loop may sample the first sampling signal in response to an edge of the feedback clock signal, thereby generating a second sampling signal. Operation S224 may be performed by the second sampler FF12 of FIG. 6.

In operation S226, the digital phase-locked loop may perform an exclusive logical sum operation between the logic level of the first sampling signal and the logic level of the second sampling signal. Operation S226 may be performed by the exclusive logical sum operator XORG2 of FIG. 6.

In operation S228, the digital phase-locked loop may change a value of the digital code based on the operation result of the exclusive logical sum operation. Operation S228 may be performed by the accumulator ACC of FIG. 6.

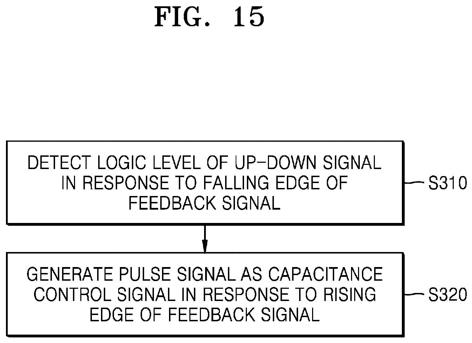

FIG. 15 is a flowchart illustrating one example of operation S300 of FIG. 12.

Referring to FIG. 15, operation S300 may include operation S310 and operation S320. Operation S310 and operation S320 may be performed by the PWM 250 described above with reference to FIGS. 7 to 10.

In operation S310, the digital phase-locked loop may detect a logic level of the up-down signal in response to a falling edge of the feedback signal.

In operation S320, the digital phase-locked loop may generate a pulse signal as the capacitance control signal in response to a rising edge of the feedback signal. The pulse signal may include a signal for shifting a phase of the output signal according to a logic level of the up-down signal.

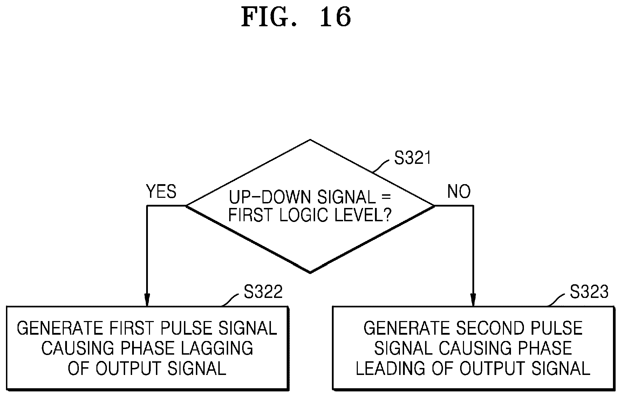

FIG. 16 is a flowchart illustrating one example of operation S320 of FIG. 15.

Referring to FIG. 16, operation S320 may include operation S321, operation S322, and operation S323. Operation S321, operation S322, and operation S323 may be performed by the PWM 250 described above with reference to FIGS. 7 to 10.

In operation S321, the digital phase-locked loop determines whether the logic level of the up-down signal is at a first logic level. In some embodiments, the digital phase-locked loop may also determine whether the logic level of the up-down signal is at a second logic level.

When the logic level of the up-down signal is at the first logic level (S321, YES), the digital phase-locked loop may, in operation S322, generate a first pulse signal that causes the phase lagging of the output signal in response to the first logic level of the up-down signal.

When the logic level of the up-down signal is at the second logic level (S321, NO), the digital phase-locked loop may, in operation S323, generate a second pulse signal that causes the phase leading of the output signal in response to the second logic level of the up-down signal.

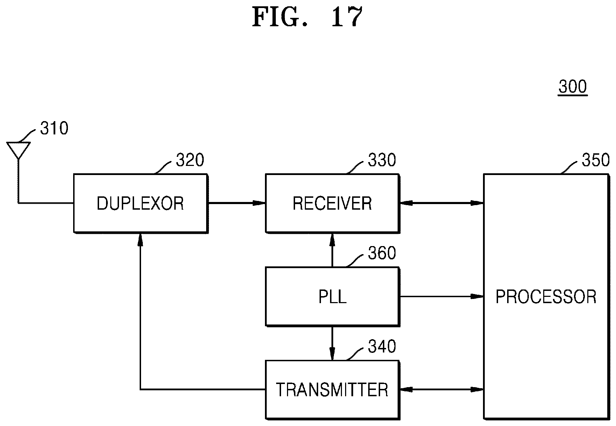

FIG. 17 is a block diagram of an electronic device 300 according to one or more embodiments.

Referring to FIG. 17, the electronic device 300 may include an antenna 310, a duplexer 320, a receiver 330, a transmitter 340, a processor 350, and a PLL 360. The duplexer 320 may transmit or receive radio frequency signals via the antenna 310. The receiver 330 may receive a radio frequency signal, convert the received radio frequency signal into a data signal, and provide the data signal to the processor 350. The transmitter 340 may receive the data signal from the processor 350, convert the received data signal into a radio frequency signal, and output the radio frequency signal. The receiver 330 or the transmitter 340 may operate in response to an output clock signal from the PLL 360. The processor 350 may control an operation of the receiver 330 or an operation of the transmitter 340. The processor 350 may process the data signal in response to the output clock signal from the PLL 360. The PLL 360 may correspond to the digital phase-locked loop 100 of FIG. 1 and/or the digital phase-locked loop 200 of FIG. 2. The embodiments described above with reference to FIGS. 1 to 16 may be applied to the PLL 360.

According to the embodiments described above, the digital phase-locked loops 100 and 200, the PLL 360, and the electronic device 300 achieve the low area and high performance by utilizing the capacitor banks having relatively small capacitance.

While certain embodiments have been particularly shown and described, it will be understood that various changes in form and details may be made therein without departing from the scope of the following claims.

## Claims

1. A digital phase-locked loop comprising:
a phase detector (120, 220) configured to compare a phase of a reference signal (FREF) and a phase of the feedback signal (FFEED), and output an up-down signal (UPDN) representing a result of the comparison;
a digital loop filter (130, 230) configured to output, based on the up-down signal (UPDN), an adjustment signal (IKP) comprising digital code for adjusting a duty ratio for a first period corresponding to a period of the feedback signal (FFEED);
a variable capacitance controller (150, 250) configured to output, based on the feedback signal (FFEED), the adjustment signal (IKP), and the up-down signal (UPDN), a capacitance control signal having the duty ratio;
a digitally controlled oscillator (140, 240) comprising:
an inductor (L),
a capacitor bank circuit configured to change a first capacitance based on the capacitance control signal, and
a negative voltage-current converter (VIC) configured to output an output signal (FOUT) having a phase adjusted based on inductance of the inductor (L) and an average of the first capacitance during the first period; and
a divider (160, 260) configured to generate the feedback signal (FFEED) by dividing the output signal (FOUT).

2. The digital phase-locked loop of claim 1, wherein the digital loop filter (130, 230) comprises:
a delay (DLY) configured to delay the up-down signal (UPDN) and output a delayed up-down signal (UPDN_D);
an exclusive logical sum operator (XORG1) configured to perform an exclusive logical sum operation, based on the up-down signal (UPDN) and the delayed up-down signal (UPDN_D), and output an operation result signal (UPDN_X1) representing a result of the exclusive logical sum operation; and
an accumulator (ACC) configured to accumulate the operation result signal (UPDN_X1), change a value of the digital code according to accumulated results, and output the adjustment signal (IKP).

3. The digital phase-locked loop of claim 1, wherein the digital loop filter (130, 230) comprises:
a first sampler (FF11) configured to sample the up-down signal (UPDN) in response to an edge of the feedback signal (FFEED), and output a first sampling signal (UPDN_R);
a second sampler (FF12) configured to sample the first sampling signal (UPDN_R) in response to the edge of the feedback signal (FFEED), and output a second sampling signal (UPDN_RR);
an exclusive logical sum operator (XORG2) configured to perform an exclusive logical sum operation, based on the first sampling signal (UPDN_R) and the second sampling signal (UPDN_RR), and output an operation result signal (UPDN_X2) representing a result of the exclusive logical sum operation; and
an accumulator (ACC) configured to change a value of the digital code, based on the operation result signal (UPDN_X2), and output the adjustment signal (IKP).

4. The digital phase-locked loop of any preceding claim, wherein the variable capacitance controller (150, 250) comprises:
a pulse generator (251) configured to receive an enable signal (AGS_END) from the digital loop filter (130, 230), sample the enable signal (AGS_END) and the up-down signal (UPDN) in response to an edge of the feedback signal (FFEED), and output the capacitance control signal, based on the sampled enable signal (PULSE) and the sampled up-down signal (UPDN_S); and
a delay cell (252) configured to determine a delay time of the sampled enable signal (PULSE) based on the adjustment signal (IKP), and output a delay signal (PULSE_D) by delaying the sampled enable signal (PULSE) by using the delay time.

5. The digital phase-locked loop of claim 4, wherein the pulse generator (251) comprises:
a first inverter (INV1) configured to invert the feedback signal (FFEED) and output an inverted feedback signal;
a first flip-flop (FF21) configured to output a feedback reset signal (FEED_R) in response to an edge of the inverted feedback signal, and be reset in response to a reset signal (PULSE_R);
a second flip-flop (FF22) configured to output the sampled enable signal (PULSE) in response to the edge of the feedback signal (FFEED), and be reset in response to the reset signal (PULSE_R);
a third flip-flop (FF23) configured to output the sampled up-down signal (UPDN_S) in response to the edge of the feedback signal (FFEED), and be reset in response to the enable signal (AGS_END);
a logical sum operator (ORG) configured to perform a logical sum operation, based on the feedback reset signal (FEED_R) and the delay signal (PULSE_D), and output the reset signal (PULSE_R);
a second inverter (INV2) configured to invert the sampled enable signal (PULSE) and output an inverted enable signal;
a negative logical sum operator (NORG) configured to perform a negative logical sum operation, based on the sampled up-down signal (UPDN_S) and the inverted enable signal, and output, as the capacitance control signal, a first signal (PWM_DN) causing phase lagging of the output signal (FOUT); and
a negative logical product operator (NANDG) configured to perform a negative logical product operation, based on the sampled up-down signal (UPDN_S) and the sampled enable signal (PULSE), and output, as the capacitance control signal, a second signal (PWM_UP) causing phase leading of the output signal (FOUT).

6. The digital phase-locked loop of claim 5, wherein the capacitor bank circuit comprises:
a first capacitor bank (CPBK1) connected between a first end of the inductor (L) and ground and configured to provide the first capacitance in response to the first signal (PWM_DN); and
a second capacitor bank (CPBK2) connected between a second end of the inductor (L) and the ground and configured to provide the first capacitance in response to the second signal (PWM_UP).

7. The digital phase-locked loop of any of claims 4-6, wherein the delay cell (252) comprises:
an inverter (INV) configured to invert the sampled enable signal (PULSE); and
a delay circuit (RCDC) configured to determine an amount of delay of a signal inverted by the inverter (INV), based on the digital code of the adjustment signal (IKP), and output the delay signal (PULSE_D).

8. The digital phase-locked loop of claim 7, wherein the inverter (INV) comprises:
a first transistor (TR71) configured to transmit a supply voltage to a first node (N21) in response to a first logic level of the sampled enable signal (PULSE); and
a second transistor (TR72) configured to transmit a ground voltage of ground to a second node (N22) in response to a second logic level of the sampled enable signal (PULSE), and
wherein the delay circuit (RCDC) comprises:
a resistor (VR) connected to the first node (N21) and the second node (N22), and
a capacitor bank array (CBA) connected between the second node (N22) and ground and configured to provide second capacitance corresponding to the amount of delay based on the digital code.

9. The digital phase-locked loop of claim 8, wherein:
the digital code comprises n bits, and n is an integer greater than or equal to 2;
the capacitor bank array (CBA) comprises a plurality of capacitor banks configured to receive the digital code of the n bits; and
a first number of capacitor banks receiving an upper bit of the digital code of the n bits is twice a second number of capacitor banks receiving a lower bit of the digital code of the n bits.

10. The digital phase-locked loop of any preceding claim, wherein the variable capacitance controller (150, 250) is configured to:
detect a logic level of the up-down signal (UPDN) in response to a falling edge of the feedback signal (FFEED); and
output, as the capacitance control signal, a pulse signal for shifting a phase of the output signal (FOUT) according to the logic level of the up-down signal (UPDN), in response to a rising edge of the feedback signal (FFEED).

11. A method of operating a digital phase-locked loop, the method comprising:
generating an up-down signal (UPDN) representing a result of a comparison of a phase of a reference signal (FREF) and a phase of a feedback signal (FFEED);
generating, based on the up-down signal (UPDN), an adjustment signal (IKP) comprising digital code for adjusting a duty ratio for a first period corresponding to a period of the feedback signal (FFEED);
generating, based on the feedback signal (FFEED), the adjustment signal (IKP), and the up-down signal (UPDN), a capacitance control signal having the duty ratio;
setting a first capacitance during a second period corresponding to the duty ratio of the capacitance control signal;
adjusting a phase, based on inductance and an average of the first capacitance during the first period, to generate an output signal (FOUT) having the phase; and
generating the feedback signal (FFEED) by dividing the output signal (FOUT).

12. The method of claim 11, wherein the generating the adjustment signal (IKP) comprises:
delaying the up-down signal (UPDN);
performing an exclusive logical sum operation between the up-down signal (UPDN) and the delayed up-down signal (UPDN_D);
accumulating an operation result of the exclusive logical sum operation; and
changing a value of the digital code, based on accumulated operation results.

13. The method of claim 11, wherein the generating the adjustment signal (IKP) comprises:
sampling the up-down signal (UPDN) in response to an edge of the feedback signal (FFEED), to generate a first sampling signal (UPDN_R);
sampling the first sampling signal (UPDN_R) in response to the edge of the feedback signal (FFEED), to generate a second sampling signal (UPDN_RR);
performing an exclusive logical sum operation between the first sampling signal (UPDN_R) and the second sampling signal (UPDN_RR); and
changing a value of the digital code, based on an operation result of the exclusive logical sum operation.

14. The method of any of claims 11-13, wherein the generating the capacitance control signal comprises:
detecting a logic level of the up-down signal (UPDN) in response to a falling edge of the feedback signal (FFEED); and
generating, as the capacitance control signal, a pulse signal for shifting a phase of the output signal (FOUT) according to the logic level of the up-down signal (UPDN), in response to a rising edge of the feedback signal (FFEED).

15. The method of claim 14, wherein the generating the pulse signal as the capacitance control signal comprises:
generating, in response to a first logic level of the up-down signal (UPDN), a first pulse signal causing phase lagging of the output signal (FOUT); and
generating, in response to a second logic level of the up-down signal (UPDN), a second pulse signal causing phase leading of the output signal (FOUT).
